## Europäisches Patentamt

## European Patent Office

## Office européen des brevets

(11) Publication number: **0 146 670**
**B1**

## EUROPEAN PATENT SPECIFICATION

(45) Date of publication of patent specification: **19.07.89**

(51) Int. Cl.⁴: **G 03 B 41/00**

(21) Application number: **84104552.9**

(22) Date of filing: **17.05.82**

(80) Publication number of the earlier application in accordance with Art. 76 EPC: **0 078 323**

(54) **Apparatus for projecting a series of images onto dies of a semiconductor wafer.**

(30) Priority: **15.05.81 US 264171**
**14.05.82 US 378370**
**15.05.81 US 264249**

(43) Date of publication of application:
**03.07.85 Bulletin 85/27**

(45) Publication of the grant of the patent:
**19.07.89 Bulletin 89/29**

(84) Designated Contracting States:
**FR**

(56) References cited:
**US-A-4 103 989**
**US-A-4 171 870**
**US-A-4 171 871**

(73) Proprietor: **GENERAL SIGNAL CORPORATION**
**PO Box 10010 High Ridge Park**
**Stamford Connecticut 06904 (US)**

(72) Inventor: **Hershel, Ronald S.**
**4828 Springhill Road**
**Albany, Oregon 97321 (US)**
Inventor: **Lee, Martin B.**
**13350 Via Arriba avenue**
**Saratoga, California 95070 (US)**

(74) Representative: **Monnier, Joseph et al**
**Cabinet Monnier 142-150, Cours Lafayette**
**F-69003 Lyon (FR)**

Courier Press, Leamington Spa, England.

## Description

The invention concerns apparatuses for microlithographically forming patterns on semiconductor wafers. More particularly, the invention concerns an improved system for one-to-one projection of pattern images onto a predetermined focal plane.

The fabrication of integrated circuits requires a method for accurately forming patterns on a semiconductor wafer. A photoengraving process known as photolithography, or simply masking, is widely employed for this purpose. The microelectronic circuit is built up layer by layer, each layer being based on a pattern received from a photolithographic mask. Such masks typically comprise a glass plate approximately the size of a wafer, the plate having a single pattern repeated many times over its surface. Each repeated pattern corresponds to a pattern to be imposed upon a layer of a wafer.

The mask patterns are derived from an optical reticle having a primary pattern which may be generated by a computer controlled light spot or electron beam which is scanned across a photosensitive plate. The reticle pattern is typically ten times the final size of the pattern to be imposed on the wafer. An image one-tenth the size of the reticle pattern is projected optically on the final mask. The reticle pattern is reproduced side by side many times on the mask, in a step-and-repeat process. Recent advances in reticle production have made it possible to produce reticles having patterns the same size as the final pattern. If such a reticle pattern could be aligned and focused onto a wafer, the mask fabrication could be substantially simplified or entirely eliminated thereby achieving a substantial savings.

The photolithographic process requires that each pattern on the mask be positioned accurately with respect to the layers already formed on the surface of the wafer. One technique is to hold the mask just off the surface of the wafer and to visually align the mask with the patterns in the wafer. After alignment is achieved, the mask is pressed into contact with the wafer. The mask is then flooded with ultraviolet radiation to expose photoresist on the surface of the wafer. The space between the wafer and the mask is often evacuated to achieve intimate contact; atmospheric pressure squeezes the wafer and the mask together. The latter apparatus is typically known as a contact printer. One defect of contact printers is that the masks quickly become abraded and useless. Since mask fabrication is expensive, it would be desirable to have another method that did not wear out the mask.

In view of the foregoing, a recent trend has been toward a technique known as projection alignment, in which an image of the mask pattern is projected onto the wafer through an optical system. In this case mask life is virtually unlimited. However, one drawback has been that wafer sizes have been increasing, and the task of designing optics capable of projecting an accurate image over the larger area is becoming more difficult. Another drawback is the moveable projection optical system used in some machines for focusing a projected image onto a wafer. It is often difficult to focus such moveable optical systems and to hold the system in focus.

Recent projection aligners have attempted to circumvent the extreme difficulty of constructing a lens capable of resolving micrometer-sized features over an area of many square inches. A much smaller area, on the order of one square centimeter, is exposed, and the exposure is repeated by stepping or scanning the projected image of the mask pattern over the wafer. Such machines are known as projection steppers. So far, all of the efforts to provide commercially acceptable projection steppers have been less than satisfactory. The use of one-to-one, or unit magnification, projection optics has become more frequent in such systems; however, achieving an adequately corrected, suitably large field in such systems has continued to present problems to those working in the art. As a result, a need has continued to exist for a projection stepping machine capable of using the now available, smaller reticles for directly forming patterns on wafers, thereby eliminating the need for a large, multiple pattern mask.

Unit magnification catadioptric lens system have been used in a variery of applications. U.S. Patent No. 2 742 817 disclosed different types of unit magnification lenses, including one in which a concave spherical mirror was combined with a plano-convex lens, the lens being positioned between the mirror and the center of curvature of the mirror. The radius of curvature of the plano-convex lens was chosen so that it did not coincide with the center of curvature of the mirror, and the index of refraction and dispersion power of the lens were chosen so that the Petzval sum of the lens was numerically equal to the curvature of the mirror. The patent indicates that the single plano-convex lens can be replaced by a cemented doublet in order to achieve color correction but that in such a simple system, considerable difficulty is encountered in correcting various aberrations. The use of an achromatic doublet was said to permit the lens to be placed closer to the focal plane than would use of a single plano-convex lens.

An article entitled "Unit Magnification Optical System Without Seidel Aberrations" was published in July, 1959 in Volume 49, No. 7 of the *Journal of the Optical Society of America* at pages 713—716. The author, J. Dyson, disclosed that when the radius of a concave mirror and a plano-convex lens are chosen so that the upper principle focus of the lens lies on the surface of the mirror and so that the centers of curvature of the spherical surfaces coincide, then the flat face of the plano-convex lens will be a common object/image plane of the system. The sagittal image plane is flat; whereas, the tangential surface is a fourth order curve. The use of prisms to couple light into and out of the lens was disclosed, as was the use of a small air gap between the prism face and image/object surface. Such an air gap was said to introduce spherical and chromatic aberrations of a sense opposite to those provided by the lens so that by proper

EP 0 146 670 B1

choice of the gap thickness and glass type, the author asserted, it would be possible to correct both types of aberrations simultaneously.

An article entitled "A Unit Power Telescope for Projection Copying" by C. G. Wynne appeared in 1969 in a book entitled *Optical Instruments and Techniques* at pages 429—434. A projection system was disclosed for use in making microcircuits by projection lithography. A concave spherical mirror, a meniscus lens, a plano-convex lens and a beam splitter were used. To correct the lens for both projection and alignment wavelengths, all spherical surfaces were required to be concentric; the material of the meniscus lens had to have a higher dispersion than that of the plano-convex lens; and to achieve chromatic correction of the Petzval curvature, the lenses had to have the same mean refractive index but different dispersions. The use of an air gap between the object/image planes and the surfaces of the beam splitter was disclosed. The author noted that "the spherical aberration caused by introducing a plane parallel air space is of opposite sign to that caused by introducing a plane parallel plate of higher refractive index. The Seidel Spherical aberration of the plane parallel air space . . . can therefore be corrected by making the beam splitter cube of slightly higher refractive index than that of the plano-convex lens to which it is cemented; and by an appropriate choice of glass dispersion, chromatic aberration can be corrected at the same time. The higher orders of spherical aberration cannot be corrected, but for small air spaces, the uncorrected residuals are very small". The Wynne lens provided improved correction over a larger field; however, the lens was quite bulky, the air gap at the image and object planes was rather small and the orientation of the image and object planes made use of the lens rather impractical in a projection stepping system. A variation of the Wynne system is shown in U.S. Patent No. 3 536 380 which disclosed a unit magnification lens in which the spherical surfaces are all concentric.

U.S. Patent No. 4 103 989 disclosed a number of unit power concentric optical systems. The patentee departed from the formula suggested by Dyson for eliminating Seidel aberrations by changing the radius of the lens relative to the mirror; however, concentricity of the spherical surfaces was maintained. The use of prisms to separate the image and object planes is taught and such an arrangement is said to be superior to the beam splitter disclosed by Dyson.

U.S. Patent No. 4 171 871 disclosed still another type of achromatic unit magnification optical system. In an effort to correct the lens over a very wide spectral range, the patentees permitted the spherical surfaces to be non-concentric and used as many as eight optical surfaces and six types of glass in an effort to correct the lens at all wave lengths within the range. A total thickness of glass of approximately 110 millimeters is used to achieve a rather small corrected field approximately 5 millimeters in height and an air gap of only 0,39 millimeters.

The invention provides an apparatus for projecting an image of a reticle pattern onto a wafer, with one-to-one magnification. The apparatus includes means for holding a reticle containing a pattern corresponding to the size of the desired wafer pattern. An illumination system substantially uniformly illuminates the reticle pattern. A stationary one-to-one projection optical system projects an image of the reticle pattern onto a predetermined focal plane. Suitable means such as a vacuum chuck holds the wafer. An alignment system steps and orients the wafer chuck to register markings on the individual dies of the wafer with corresponding markings on the projected image of the reticle pattern. A fluid servo system acts on the chuck to hold at least a portion of the wafer in the predetermined focal plane of the projection optical system.

The unit magnification optical projection system of the invention comprises

a concave spherical reflecting surface having an optical axis and a first center of curvature;

an achromatic lens positioned between said reflecting surface and said first center of curvature, said achromatic lens comprising a meniscus lens made from a glass having a first index of refraction, said meniscus lens having a first convex surface facing said reflecting surface and a second center of curvature spaced from said first center of curvature, said meniscus lens also having a concave surface facing away from said reflecting surface, said concave surface having a third center of curvature spaced from said first and second centers of curvature;

said achromatic lens also comprising a plano-convex lens made from a glass having a second index of refraction lower than said first index, said plano-convex lens having a second convex surface facing said concave surface, said second convex surface having a fourth center of curvature spaced from said first and second centers of curvature, said plano-convex lens also having a first flat surface facing away from said reflecting surface, said first flat surface being spaced from said first, second and third centers of curvature; and

said achromatic lens further comprising first and second prisms for coupling light into and from separate fields on said first flat surface, said prisms being made from a glass having a third index of refraction higher than said first and second indices, each of said prisms having an optical path length and a second flat surface facing one of the image and object planes of said projection system, said optical path length being such that said image and object planes are spaced sufficiently from said second flat surfaces to preclude focusing of dust particles;

said achromatic lens (54) consisting of said meniscus lens (53), said plano-convex lens (55) and said prisms (56, 57);

said reflecting surface (E) having radius of curvature of 264 mm;

said first convex surface (D) having a radius of curvature of 74,95 mm; and

3

said concave surface (C) and said second convex surface having a radius of curvature of 35 mm, while said first convex surface (D) is spaced 189,32 mm of air along said optical axis (51) from said reflecting surface (E);

said first convex surface (D) is spaced 37,60 mm of light flint glass from said concave surface (C);

said second convex surface is spaced 10,02 mm of dense flint glass from said first flat surface (B);

said first flat surface (B) is spaced 26,08 mm of dense crown glass from said second flat surfaces (A); and

said second flat surfaces (A) are spaced l,79 mm of air from said image and object planes;

said light flint glass being Schott SF2;

said dense flint glass Schott KF6; and

said dense crown glass Schott LAKN7 and

said concave surface (C) of said meniscus lens and said second convex surface (D) of said plano-convex lens being cemented together, whereby said third and fourth centers of curvature are substantially conincident; wherein

said image plane is horizontal and said object plane and said optical axis (51) are set at acute angles to said image plane.

Fig. 1 is a plan view of a typical wafer having a plurality of dies formed thereon.

Fig. 2 is an enlarged fragmentary view of the wafer of Fig. 1, showing the dies on the wafer and the fiducial markers on the dies.

Fig. 3 is an optical schematic view of the illumination system of the projection stepper.

Fig. 4 is an optical schematic view of the projection system and fiducial marker detection system of the projection stepper.

Fig. 5 is a simplified, enlarged, partial perspective view of the illumination and projection optical system.

Fig. 6 is a partial sectional view to the illumination and projection optical systems.

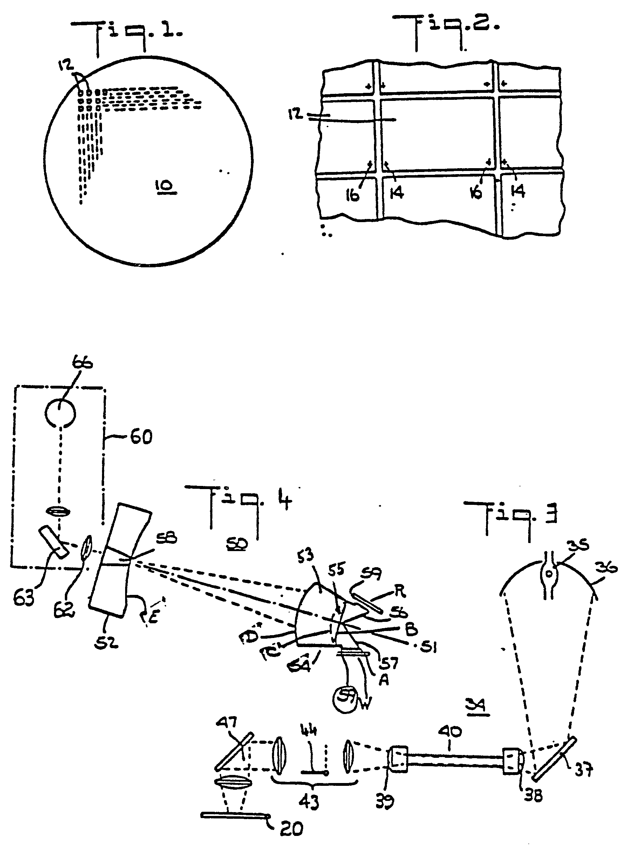

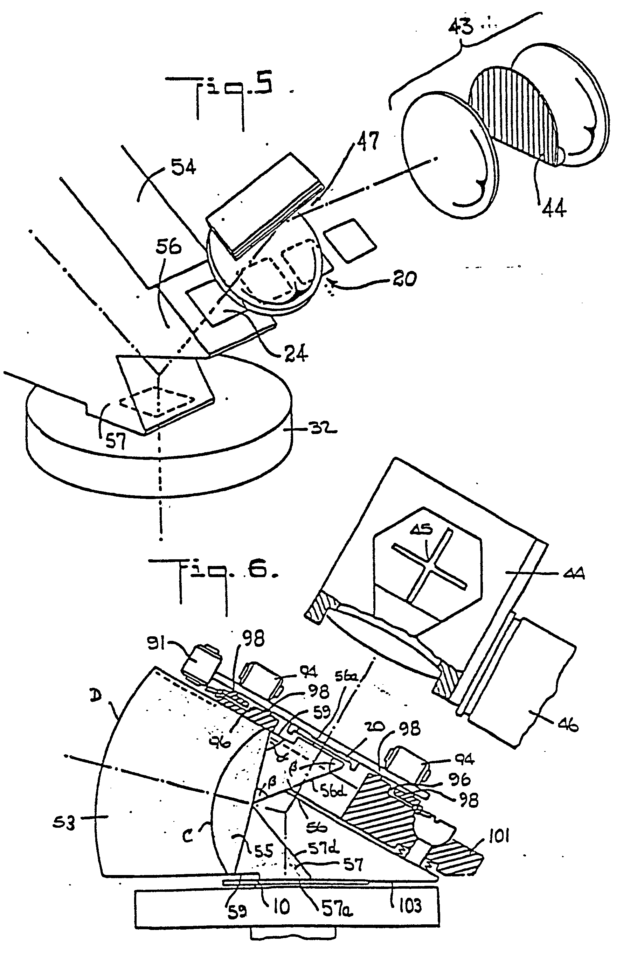

Figures 1 and 2 show a wafer 10 provided with a plurality of dies 12 arranged in rows and columns. Each die 12 has a pair of fiducial markers 14 and 16 at adjacent or opposite corners of the die. The markers 14 and 16 may be in the form of small "+" signs. As will be described in detail hereinafter, the markers 14 and 16 are used to align the dies with the projected image of the reticle pattern.

In operation a reticle 20 shown in fig. 3 and 6 is disposed between illumination system 34 and projection system 50. An alignment system controls the movement of the wafer positioning system to align the dies 12 of the wafer 10 shown in Fig. 1 and 2 with the projected image of the pattern on reticle 20. A focusing system (not shown) maintains the projected image of the reticle pattern in optimal focus on the wafer.

Holding means, such as a vacuum chuck 32 shown in Fig. 5 is disposed below projection system 50.

A reticle illumination system 34, shown in fig. 3, 4 and 6, comprises a light source 35 such as a mercury short arc lamp having rating of 200 W. The mercury lamp is pulsed at 500 W during wafer exposure and held at a standby power of 100 W during alignment and other operations. Thus, the average power consumption of the lamp during a typical wafer stepping operation is approximately 200 W.

An elliptical reflector 36 focuses the arc image of the lamp onto one end of a light pipe 40. A dichroic mirror 37 reflects only a selected wavelength band of light, thereby preventing the infrared and ultraviolet portions of the lamp spectrum from reaching the reticle. Hemispheric lenses 38, 39 are cemented to opposite ends of the light pipe 40 which aid the coupling of the light in and out of the pipe 40 as well as protect the end faces thereof. Light leaves the light pipe 40, passes through lens 39 and a shutter stator 43 having moveable shutter 44, and a lens and mirror arrangement 47 for illuminating the reticle 20.

The function of the light pipe 40 is to efficiently convert the nonuniform intensity distribution of light at the lamp end to a uniform distribution of light at the reticle end. Internal reflections within the light pipe are essentially lossless. The incoming light is folded and integrated with each internal reflection, thereby reducing nonuniformities. A main advantage of the light pipe 40 is that misalignment of the lamp or light source 35 merely reduces the total output intensity without noticably affecting the uniformity.

After a predetermined exposure, monitored by a detector (not shown) located near the output of illumination system 34, the lamp power is dropped to 100 W and simultaneously shutter 44 is moved into the aperture plane. A small fraction of the light from source 35 passes through a cross opening 45 in shutter 44 and illuminates the marker 28, 30 on the reticle 20. A high pass dielectric filter (not shown) covers the opening 45 to prevent the g and h lines from exposing the wafer during alignment. On certain wafer levels, it may be necessary to use the mercury g line to enhance the alignment signal. In this case, it can be shown that the relative exposure value of the intensity reaching the wafer is 2% during normal exposure.

Optical projection system 50, shown in Figs. 4 and 6 comprises two components: a 10.16 cm front surface spherical mirror 52 and a cemented achromat-prism assembly 54. Assembly 54 comprises a cemented meniscus element 53 and plano-convex element 55 which correct any astigmatism of the concave mirror 52 at one-to-one for the g and h mercury lines. A pair of prisms 56, 57 are part of the optical design and also separate the reticle pattern plane R from the wafer image plane W, as seen in fig. 4. To provide adequate clearance between vacuum chuck 32 and reticle 20, the optical axis 51 is tilted at 15 degrees from the horizontal, thereby placing reticle 20 at 30 degrees to the X-Y plane of movement of vacuum chuck 32. Thus, light passing through pattern 24 is reflected by the prism 56 through the lenses 55, 53 onto the mirror 52, back through the lenses 53, 55 and prism 57 and onto a wafer 10 positioned on vacuum chuck 32.

Mirror 52 includes a conical aperture 58 which is part of alignment system 60. Automatic alignment of each die with the projected reticle image is accomplished through the projection system 50 using a type of dark field imaging to produce an alignment signal. The design of the projection system 50 is simplified by providing for independent movement of the wafer to achieve proper focus, so that the optical members may remain stationary.

As shown in Fig. 4 mirror 52 and composite achromat-prism assembly 54 are disposed symetrically about optical axis 51. The object plane or reticle pattern plane R lies on one side of the axis 51 and the image or wafer plane W lies on the opposite side. Projection system 50 is best described with reference to the following Table I. It will be appreciated by those skilled in the art that the Table describes the optical system in accordance with the optical surfaces and materials through which light passes along one half of the optical path. Column 1 identifies the successive surfaces. Column 2 lists the thicknesses in millimeters of material behind the surface. Column 3 lists geometric date and Column 4 lists materials. The materials for surfaces B, C, D (prism 56 or 57, plano-convex element 55 and meniscus element 53, respectively) are identified by the names used by Schott Company, a well-known supplier of optical glass. Those trained in the art will recognize that the spherical surfaces are non-concentric; that is, their centers of curvature are not coincident. This feature allows a higher degree of image correction than would be possible with a concentric design.

TABLE I

| 1 Surface | 2 Thickness in mm | 3 Radius of Curvature in mm | 4 Material |
|---|---|---|---|
| A | 1,79 | ∞(flat) | AIR |
| B | 26,80 | ∞(flat) | LAKN7 |
| C | 10,02 | 35,00 | KF6 |
| D | 37,60 | 74,95 | SF2 |
| E | 189,37 | 264,00 | AIR |

Those skilled in the art will recognize that the Schott material LAKN7 is a lanthium dense crown glass; the Schott material KF6 is a light flint glass; the Schott SF2 is a dense flint glass.

The prisms 56, 57 perform a plurality of functions. The apex angle α of both prisms 56, 57 is 75°; the opposite equal interior angles β are 52,5°. See Fig. 6 prisms 56, 57 couple light into and out of projection system 50. In addition, the prisms are fashioned to provide a 1,78 mm air gap between surface 56a and reticle 20 and between surface 57a and wafer 10. Such an air gap is required for the needed mechanical clearances to move the wafer 10 and the reticle 20 into and out of the respective wafer plane W and reticle pattern plane R. The air gap is sufficiently large that dust particles as large as 200 microns will not adversely affect the system. Such particles will not be focused in a 1,78 mm air gap. It is the unique combination of prism material and angular configuration which efficiently couples the light through the system 50 and provides the large air gap.

Another advantage of the optical system 50 is that all the optical elements 53, 55, 56, 57 are all fashioned from preferred glasses. Such glasses are more easily and consistently manufactured than are other kinds of glasses.

Three of the 10 optical surfaces are spherical, two of which require fabrication to better than λ/10. Surfaces A and B are polished flat to λ/4. The prism diagonals 56d and 57d are specified to λ/20 to minimize lens-to-lens distortion. Autoalignment system 60 can be used to align the concave mirror 52 to the prism assembly 54 by adjusting for zero lateral 55, 53 color. With this alignment procedure, the decentering tolerance for plano-convex element 55 and meniscus element 53 is large by most design standards, approximately 125 μm. Cementing the prisms 56, 57 to the planar side of meniscus element 53 requires some care to avoid vignetting of rays close to the edges of the image field.

Optical coatings are applied to the air-glass surfaces A and D to maintain spurious reflections and ghost images to less than 1% of peak exposure. This is accomplished with a single λ/4 coating of MgF$_2$ on the glass-air surfaces. Due to the prism design, total internal reflection occurs at all ray angles, thus avoiding the requirement for metallic or dielectric coatings on the prism diagonals 56d, 57d, which would introduce polarization and phase disturbances with possible adverse effects on the image quality. The concave mirror 52 is coated with protected aluminum with approximately 90% reflectivity from 500—600 nm. Including absorption and surface reflections, the overall transmission through the projection lens is 80% in the 400—450 nm spectral band of resist sensitivity.

The design performance of an actual projection system 50 is summarized in Table II. A Strehl ratio of 1.0 signifies a perfect lens whose performance is limited only by fabrication errors and defocus. The Strehl ratio is maximized at two wavelengths over a specified field height. The design was optimized at the g and h mercury lines (436 nm and 405 nm respectively), achieving a minimum Strehl ratio of .99 over a 16.8 mm field radius. The residual astigmatism is held to within ±.65 µm of the focal plane which corresponds to a peak-to-peak wavefront error over the aperture of $\lambda/15$.

TABLE II

Lens Performance

| | |
|---|---|
| Numerical aperture | .30 |
| Field Height | 16,8 mm |
| Corrected Bandpass | 400—450 nm |
| Alignment Bandpass | 400—600 nm |
| Strehl ratio | >.99 |
| Min usable linewidth | .80 m |
| Depth of focus (1 um lines) | 3,5 m |
| Telecentricity | <1,0 mrad |

It is estimated that a 4,8 µm depth of focus is required to maintain linewidth control to better than 0,125 µm. This estimate assumes a partial coherence of σ = 0.4 which results from using an f/4 illuminator with an f/l,6 projection lens. The estimated linewidth variation is based on a ±40% variation in actual resist exposure caused by changes in wafer reflectivity and topography. Subtracting out the residual astigmatism, the usable depth of focus becomes 3.5 µm. The minimum geometry attainable in production is estimated at 0.8 µm, based on a 1 µm depth of focus. Achieving this resolution, therefore, depends on the underlying topography and reflectivity associated with a given wafer level.

An important consideration in designing a one-to-one projection system is the requirement to locate telecentric stops at reticle pattern plane R and wafer image plane W. When this requirement has been met, rays entering parallel to the optical axis on the reticle side exit parallel on the wafer side. This feature ensures that no error in the size of the projected image results from small changes in the conjugate planes. As seen in Table II, the projection system 50 departs only 1 mrad from perfect telecentricity. As a result, the axial position of reticle 20 can vary as much as ± 0,0051 cm; and yet the magnification error will be less than ,05 mm over the entire exposure area.

Another factor to be considered with this type of lens is the degradation of the image quality due to absorption of near uv radiation within the lens elements. This problem has been particularly troublesome in lenses designed to work in the 365 nm region. With the proper choice of glasses used in prism assembly 54 and complete rejection of wavelengths below 400 nm by illumination system 34, the optical effects due to absorption can be made negligible.

A computer simulation of thermal gradients produced in the meniscus element 53 was performed using the manufacturer's values for absorption and thermal conductivity of the glass. The maximum time-averaged flux through the recticle was estimated at 200 mW/cm², stepping one exposure per second. Assuming the worst case of a clear reticle pattern with an area of 1.5cm² the computer simulation yielded a maximum temperature gradient of ,07°C/cm within the meniscus lens 53. Estimates of the inhomogeneity in the index of refraction, derived from the simulated temperature profiles, never exceeded $1,5 \times 10^{-6}$ which is comparable to the best available optical cut blanks.

Alignment system 60 comprises the necessary optical mechanical features to enable the stepping machine to adjust itself for different size recticle patterns and for reticle assembly errors. See fig. 4. Starting at spherical mirror 52, light which was scattered into the dark central cone by the frosty wafer or a fiducial marker passes through aperture 58, which formed the dark cone. The light beam is partially focussed by a 147 mmf achromat lens 62 and bounced up toward tube 66 by a folding mirror 63.

6

# EP 0 146 670 B1

## Claims

1. A unit magnification, achromatic, anastigmatic optical projection system of the catodioptric type particularly suited for use in microlithography, said projection system (50) being characterized in that it comprises

a concave spherical reflecting surface (E) having an optical axis (51) and a first center of curvature;

an achromatic lens (54) positioned between said reflecting surface (E) and said first center of curvature, said achromatic lens (54) comprising a meniscus lens (53) made from a glass having a first index of refraction, said meniscus lens having a first convex surface (D) facing said reflecting surface (E) and a second center of curvature spaced from said first center of curvature, said meniscus lens also having a concave surface (C) facing away from said reflecting surface (E), said, concave surface (C) having a third center of curvature spaced from said first and second centers of curvature;

said achromatic lens (54) also comprising a plano-convex lens made from a glass having a second index of refraction lower than said first index, said plano-convex lens having a second convex surface (D) facing said concave surface (E), said second convex surface (D) having a fourth center of curvature spaced from said first and second centers of curvature, said plano-convex lens (55) also having a first flat surface (B) facing away from said reflecting surface (E), said first flat surface (B) being spaced from said first, second and third centers of curvature; and

said achromatic lens (54) further comprising first and second prisms (56, 57) for coupling light into and from separate fields on said first flat surface (B), said prisms being made from a glass having a third index of refraction higher than said first and second indices, each of said prisms having an optical path length and a second flat surface (A) facing one of the image and object planes of said projection systems (50), said optical path length being such that said image and object planes are spaced sufficiently from said second flat surfaces to preclude focusing of dust particles,

said achromatic lens (54) consisting of said meniscus lens (53), said plano-convex lens (55) and said prisms (56, 57);

said reflecting surface (E) having a radius of curvature of 264 mm; said first convex surface (D) having a radius of curvature of 74,95 mm; and said concave surface (C) and said second convex surface having a radius of curvature of 35 mm, while said first convex surface (D) is spaced 189,32 mm of air along said optical axis (51) from said reflecting surface (E); said first convex surface (D) is spaced 37,60 mm of light flint glass from said concave surface (C); said second convex surface (D) is spaced 10,02 mm of dense flint glass from said first flat surface (B); said first flat surface (B) is spaced 26,08 mm of dense crown glass from said second flat surfaces (A); and said second flat surfaces (A) are spaced l,79 mm of air from said image and object planes;

said light flint glass being Schott SF2;

said dense flint glass, Schott KF6; and

said dense crown glass, Schott LAKN7 and

said concave surface (C) of said meniscus lens (53) and said second convex surface (D) of said plano-convex lens (55) being cemented together, whereby said third and fourth centers of curvature are substantially coincident; wherein

said image plane is horizontal and said object plane and said optical axis (51) are set at acute angles to said image plane.

2. A projection system according to claim 1, characterized in that said achromatic lens (54) is tapered inwardly from said meniscus lens (53) toward said first flat surface (B) to provide clearance for movement of a wafer (10) and a reticle (20) at said image and object planes, respectively.

3. An apparatus for use in a microlithography system characterized by an optical system as specified in claim 1.

4. An apparatus according to claim 3, characterized by an aperture (58) provided in the optical axis of said reflecting surface (E).

## Patentansprüche

1. Vergrößerndes, achromatisches, anastigmatisches optisches Projektionssystem (50) vom catodioptrischen Typ, insbesondere zur Verwendung in der Mikrolithographie, gekennzeichnet durch

eine konkave, sphärische reflektierende Oberfläche (E) mit einer optischen Achse (51) und einem ersten Krümmungsmittelpunkt;

eine zwischen der reflektierenden Oberfläche (E) und dem ersten Krümmungsmittelpunkt angeordnete achromatische Linse (54) mit einer Meniskuslinse aus einem Glas mit einem ersten Brechungsindex, wobei die Meniskuslinse eine erste, der reflektierenden Oberfläche (E) zugewandte konvexe Ober-Oberfläche (D) sowie einen vom ersten Krümmungsmittelpunkt im Abstand liegenden zweiten Krümmungsmittelpunkt und eine von der reflektierenden Oberfläche (E) abgewandte konkave Oberfläche (C) aufweist, mit einem vom ersten und vom zweiten Krümmungsmittelpunkt im Abstand vorgesehenen dritten Krümmungsmittelpunkt, während die achromatische Linse (54) außerdem eine plankonvexe Linse (55) besitzt aus einem Glas mit einem zweiten Brechungsindex, der niedriger als der erste Index ist und die

7

plankonvexe Linse (55) eine zweite, der konkaven Oberfläche (E) zugewandte konvexe Oberfläche (D) mit einem vierten, vom ersten und vom zweiten Krümmungsmittelpunkt im Abstand befindlichen Krümmungsmittelpunkt sowie eine erste, von der reflektierenden Oberfläche (E) abgewandte ebene Oberfläche (B) besitzt, welche vom ersten, vom zweiten und vom dritten Krümmungsmittelpunkt im Abstand liegt, und,

die achromatische Linse (54) weiterhin ein erstes und ein zweites Prisma (56, 57) aufweist, die Licht in getrennte Felder an der ebenen Oberfläche (B) und von denselben weg leiten und aus einem Glas mit einem dritten Brechungsindex bestehen, der höher ist als die genannten ersten und zweiten Indices, wobei jedes Prisma eine optische Weglänge sowie eine zweite, einer der Bild- und Objektebenen des Projektionssystems (50) zugewandte ebene Oberfläche (A) besitzt und die optische Weglänge derart ist, daß die Bild- und Objektebene von den zweiten ebenen Oberflächen in ausreichender Entfernung liegt, um ein Fokussieren von Staubteilzu verhindern, und

die achromatische Linse (54) aus der Meniskuslinse (53), der plankonvexen Linse (55) und den Prismen (56, 57) besteht, und

wobei die reflektierende Oberfläche (E) einen Krümmungsradius von 264 mm, die erste konvexe Oberfläche (D) einen Krümmungsradius von 74, 95 mm und die konkave Oberfläche (C) sowie die zweite konvexe Oberfläche einen Krümmungsradius von 35 mm aufweisen, während der Abstand der ersten konvexen Oberfläche (D) von der reflektierenden Oberfläche (E) längs der optischen Achse (51) 189,32 mm Luftweg und von der konkaven, Oberfläche (C) 37,60 mm Weg in leichtem Flintglas beträgt, die zweite konvexe Oberfläche (D) von der ersten ebenen Oberfläche (B) im Abstand von 10,02 mm Weg in schwerem Flintglas liegt, die erste ebene Oberfläche (B) einen Abstand von 26,08 mm Weg in schwerem Kronglas von den genannten zweiten ebenen Oberflächen (A) hat, die ihrerseits in einem Abstand von l,79 mm Luftweg von den Bild- und den Objektebenen liegen,

das leichte Flintglas Schott SF2, das schwere Flintglas Schott KF6 und das schwere Kronglas Schott LAKN7 ist und

die konkave Oberfläche (C) der Meniskuslinse (53) mit der zweiten konvexen Oberfläche (D) der plankonvexen Linse (55) verbunden ist, wobei der dritte und der vierte Krümmungsmittelpunkt im wesentlichen zusammenfallen, die Bildebene waagerecht ist und die optischen Achsen (51) unter spitzen Winkeln zu ihr verlaufen.

2. Projektionssystem nach Anspruch 1, dadurch gekennzeichnet, daß sich die achromatische Linse (54) innen von der Meniskuslinse (53) zur ersten ebenen Oberfläche (B) hin verjüngt und dadurch Raum für die Bewegung der Platte (10) und des Fadenkreuzes (20) an der Bild- bzw. der Objektebene schafft.

3. Vorrichtung zur Verwendung in einem Mikrolithographiesystem, gekennzeichnet durch ein optisches System nach Anspruch 1.

4. Vorrichtung nach Anspruch 3, gekennzeichnet durch eine in der optischen Achse der reflektierenden Oberfläche (E) vorgesehene Öffnung (58).

**Revendications**

1. Système optique de projection anastigmate, achromatique à agrandissement unite, du type catadioptrique, convenant particulièrement à la microlithographie, ledit système de projection (50) etant caractérisé en ce qu'il comprend:

une surface rèfléchissante concave (E) comportant un axe optique (51) et un premier centre de courbure;

un objectif achromatique (54) disposé entre cette surface rèfléchissante (E) et le premier centre de courbure precité, cet objectif achromatique (54) comprenant un ménisque (53) fait d'un verre possédant un premier indice de réfraction, lequel ménisque comporte une première face convexe (D) située en vis-à-vis de ladite surface réfléchissante (E) et un second centre de courbure situé à une certaine distance du premier centre précité, ce ménisque comportant également une face concave (C) tournée à l'opposé de ladite surface refléchissante (E), laquelle face concave (C) posséde un troisième centre de courbure ecarte du premier et du second;

ledit objectif achromatique (54) comprenant aussi une lentille plano-convexe (55) faite d'un verre possedant un second indice de rèfraction inférieur au premier indice ci-dessus, cette lentille plano-convexe comportant une seconde face convexe (D) situee en vis-à-vis de la face concave précitée (E), cette seconde face convexe (D) comportant un quatrième centre de courbure ecarte du premier et du second, ladite lentille plano-convexe (55) comportant également une première face plane (B) orientée à l'opposé de ladite surface réfléchissante (E), cette première surface plane (B) étant ecartee du premier, du second et du troisième centre de courbure; et

ledit objectif (54) achromatique comprenant en outre un premier et un second prisme (56, 57) pour guider la lumiére vers des domaines separes ou à partir de tels domaines sur ladite première surface plane (B), lesquels prismes sont faits d'un verre qui possède un troisième indice de refraction supérieur au premier et au second indice ci-dessus, chacun de ces prismes comportant une certaine longueur de trajet optique ainsi qu'une seconde face plane (A) situee en vis-à-vis de l'un des plans image et objet de l'objectif de projection (50), laquelle longueur de trajet optique est telle que les plans image et objet précités sont

8

suffisamment distants desdites secondes surfaces planes pour empêcher toute mise au point de particules de poussière;

ledit objectif achromatique (54) étant compose dudit ménisque (53), de ladite lentille plano convexe et desdits prismes (56, 57)

ladite surface réfléchissante (E) a un rayon de courbure de 264 mm; la première face convexe (D) un rayon de courbure de 74,95 mm; et ladite face concave (C) ainsi que la seconde face convexe un rayon de courbure de 35 mm, tandis que la premiére face convexe (D) est écartée d'un espace d'air de 189,32 mm le long de l'axe optique à partir de la surface réfléchissante; cette première face convexe (D) est écartée d'un espace de verre flint léger de 37,60 mm à partir de la face concave (C); la seconde face convexe (D) est écartée d'un espace de verre flint dense de 10,02 mm à partir de la première face plane (B); cette première face plane (B) est écartée d'un espace de verre crown dense de 26,08 mm à partir des secondes faces planes (A); et ces secondes faces planes (A) sont écartées d'un espace d'air de 1,79 mm à partir des plans image et objet;

le verre flint leger ètant le Schott SF2, le verre flint dense, le Schott KF6, et le verre crown dense, le Schott LAKN7;

la surface concave (C) dudit ménisque (53) et la seconde surface convexe (D) de ladite lentille plano-convexe (55) sont collées l'une à l'autre, grâce à quoi lesdits premier et quatri'ème centres de courbure sont substantiellement en coïncidence; le plan image est ainsi horizontal, tandis que le plan objet et l'axe optique (51) sont orientés à angle aigu par rapport audit plan image.

2. Système de projection suivant la revendication 1, caractérisé en ce que l'objectif achromatique (54) est creusé interieurement à partir du mènisque (53) en direction de la premiere surface plane (B) afin de ménager un espace pour le déplacement d'une plaquette (10) et d'un réticule (20) respectivement dans lesdits plans image et objet.

3. Appareil utilisable dans un système de microdithographie, caractérisé par un système optique suivant la revendication 1.

4. Appareil suivant la revendication 3, caracterise par une ouverture (58) prevue dans l'axe optique de ladite surface réfléchissante (E).

EP 0 146 670 B1

Fig.1.

Fig.2.

Fig. 4

Fig.3

EP 0 146 670 B1

Fig. 5.

Fig. 6.